(19) **Europäisches Patentamt / European Patent Office / Office européen des brevets**

(11) **EP 4 560 330 A2**

(12) **EUROPEAN PATENT APPLICATION**
published in accordance with Art. 153(4) EPC

(43) Date of publication:
**28.05.2025 Bulletin 2025/22**

(21) Application number: **23868472.4**

(22) Date of filing: **08.09.2023**

(51) International Patent Classification (IPC):
$G01R\ 31/36$ (2020.01)  $G01R\ 31/396$ (2019.01)
$G01R\ 31/392$ (2019.01)  $G01R\ 31/382$ (2019.01)
$G01R\ 31/385$ (2019.01)  $G01R\ 19/10$ (2006.01)
$G01R\ 31/52$ (2020.01)  $G01R\ 19/00$ (2006.01)
$G01R\ 19/165$ (2006.01)

(52) Cooperative Patent Classification (CPC):
**G01R 19/00; G01R 19/10; G01R 19/165;
G01R 31/36; G01R 31/382; G01R 31/385;
G01R 31/392; G01R 31/396; G01R 31/52;
Y02E 60/10**

(86) International application number:
**PCT/KR2023/013537**

(87) International publication number:
**WO 2024/063418 (28.03.2024 Gazette 2024/13)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **23.09.2022 KR 20220120916
04.08.2023 KR 20230102473**

(71) Applicant: **LG Energy Solution, Ltd.
Seoul 07335 (KR)**

(72) Inventors:
• **SUNG, Yong Chul
  Daejeon 34122 (KR)**
• **KIM, Cheol Taek
  Daejeon 34122 (KR)**

(74) Representative: **Plasseraud IP
104 Rue de Richelieu
CS92104
75080 Paris Cedex 02 (FR)**

(54) **BATTERY DIAGNOSIS DEVICE AND BATTERY DIAGNOSIS METHOD**

(57) According to some embodiments disclosed herein, a battery diagnosis apparatus includes a sensor configured to generate first open circuit voltage (OCV) data by measuring an OCV from a diagnosis target battery and a controller configured to obtain first SOC data regarding a state of charge (SOC) of the diagnosis target battery based on the first OCV data, derive second SOC data for estimating the SOC of the diagnosis target battery based on the first SOC data, obtain second OCV data of the diagnosis target battery based on the second SOC data, and diagnose a state of the diagnose target battery based on the first OCV data and the second OCV data.

100

BATTERY DIAGNOSIS APPARATUS
130

SENSOR
131

CONTROLLER
132

FIG.2

EP 4 560 330 A2

**Description**

**[TECHNICAL FIELD]**

CROSS-REFERENCE TO RELATED APPLICATION

This application claims priority to and the benefit of Korean Patent Application No. 10-2022-0120916 filed in the Korean Intellectual Property Office on September 23, 2022, and Korean Patent Application No. 10-2023-0102473 filed in the Korean Intellectual Property Office on August 4, 2023, the entire contents of which are incorporated herein by reference.

TECHNICAL FIELD

Embodiments disclosed herein relate to a battery diagnosis apparatus and method.

**[BACKGROUND ART]**

Recently, research and development of secondary batteries have been actively performed. Herein, the secondary batteries, which are chargeable/dischargeable batteries, may be interpreted as including all of conventional nickel (Ni)/cadmium (Cd) batteries, Ni/metal hydride (MH) batteries, etc., and recent lithium-ion batteries. Among secondary batteries, lithium-ion batteries may have a higher energy density than conventional Ni/Cd batteries, Ni/MH batteries, etc., and may be manufactured to be small and lightweight, allowing them to have high usability in terms of power sources for mobile devices. Recently, the lithium ion battery is attracting attention as a next-generation energy storage medium as a usage range thereof is expanded to a power source of electric vehicles.

Diagnosis of abnormal behavior may be performed based on a battery voltage to inspect the manufacturing quality of batteries or to diagnose whether a defect has occurred. For example, abnormal behavior of the battery voltage may be diagnosed by using the deviation of cell voltages of battery cells, but this diagnosis method has a low diagnosis accuracy.

**[DISCLOSURE]**

**[TECHNICAL PROBLEM]**

Embodiments disclosed herein aim to provide a battery diagnosis apparatus and method by which abnormality of a voltage behavior may be diagnosed even when there is a little change in a battery voltage.

Technical problems of the embodiments disclosed herein are not limited to the above-described technical problems, and other unmentioned technical problems would be clearly understood by one of ordinary skill in the art from the following description.

**[TECHNICAL SOLUTION]**

According to some embodiments disclosed herein, a battery diagnosis apparatus includes a sensor configured to generate first open circuit voltage (OCV) data by measuring an OCV from a diagnosis target battery and a controller configured to obtain first SOC data regarding a state of charge (SOC) of the diagnosis target battery based on the first OCV data, derive second SOC data for estimating the SOC of the diagnosis target battery based on the first SOC data, obtain second OCV data of the diagnosis target battery based on the second SOC data, and diagnose a state of the diagnose target battery based on the first OCV data and the second OCV data.

According to some embodiments, the diagnosis target battery may include a plurality of battery cells, and the first OCV data may include a plurality of OCV values measured at a plurality of time points for each of the plurality of battery cells.

According to some embodiments, the controller may be further configured to calculate an average SOC value of a plurality of SOC values converted from the plurality of OCV values for each battery cell, calculate a relative capacity value of each battery cell based on the average SOC value, and calculate a plurality of estimated SOC values of each battery cell at the plurality of time points based on the relative capacity value.

According to some embodiments, the controller may be further configured to calculate a pseudoinverse matrix of an average SOC matrix indicating the average SOC value of each battery cell and calculate a relative capacity matrix indicating the relative capacity value by multiplying the pseudoinverse matrix by an SOC matrix indicating the plurality of SOC values for each battery cell.

According to some embodiments, the controller may be further configured to calculate an estimated SOC matrix indicating the plurality of estimated SOC values of each battery cell by multiplying the average SOC matrix by the relative capacity matrix.

According to some embodiments, the controller may be further configured to derive OCV deviation data based on a difference between the first OCV data and the second OCV data and diagnose the state of the diagnose target battery based on the OCV deviation data.

According to some embodiments, the OCV deviation data may include a plurality of OCV deviation values of each battery cell at the plurality of time points, and the controller may be further configured to calculate a plurality of OCV deviation change amounts indicating a difference between an OCV deviation value at a current time point and an OCV deviation value at a previous time point, based on the plurality of OCV deviation values of each battery cell and diagnose a state of each battery cell based on the plurality of OCV deviation change amounts of each battery cell.

According to some embodiments, the controller may be further configured to diagnose that abnormality occurs in a first battery cell among the plurality of battery cells, when the plurality of OCV deviation change amounts of the first battery cell is greater than an upper limit of a normal range or is less than a lower limit of the normal range.

According to some embodiments, the controller may be further configured to convert the first OCV data into the first SOC data based on an OCV-SOC mapping table and convert the second SOC data into the second OCV data based on the OCV-SOC mapping table.

According to some embodiments disclosed herein, a battery diagnosis method includes generating first open circuit voltage (OCV) data by measuring an OCV from a diagnosis target battery, obtaining first SOC data regarding a state of charge (SOC) of the diagnosis target battery based on the first OCV data, deriving second SOC data for estimating the SOC of the diagnosis target battery based on the first SOC data, obtaining second OCV data of the diagnosis target battery based on the second SOC data, and diagnosing a state of the diagnose target battery based on the first OCV data and the second OCV data.

According to some embodiments, the diagnosis target battery may include a plurality of battery cells, and the first OCV data may include a plurality of OCV values measured at a plurality of time points for each of the plurality of battery cells.

According to some embodiments, the deriving of the second SOC data may include calculating an average SOC value of a plurality of SOC values converted from the plurality of OCV values for each battery cell, calculating a relative capacity value of each battery cell based on the average SOC value, and calculating a plurality of estimated SOC values of each battery cell at the plurality of time points based on the relative capacity value.

According to some embodiments, the calculating of the relative capacity value may include calculating a pseudoinverse matrix of an average SOC matrix indicating the average SOC value of each battery cell and calculating a relative capacity matrix indicating the relative capacity value by multiplying the pseudoinverse matrix by an SOC matrix indicating the plurality of SOC values for each battery cell.

According to some embodiments, the calculating of the plurality of estimated SOC values may include calculating an estimated SOC matrix indicating the plurality of estimated SOC values of each battery cell by multiplying the average SOC matrix by the relative capacity matrix.

According to some embodiments, the diagnosing of the state of the diagnosis target battery may include deriving OCV deviation data based on a difference between the first OCV data and the second OCV data and diagnosing a state of the diagnose target battery based on the OCV deviation data.

According to some embodiments, the OCV deviation data may include a plurality of OCV deviation values of each battery cell at the plurality of time points, and the diagnosing of the state of the diagnosis target battery may include calculating a plurality of OCV deviation change amounts indicating a difference between an OCV deviation value at a current time point and an OCV deviation value at a previous time point, based on the plurality of OCV deviation values of each battery cell and diagnosing a state of each battery cell based on the plurality of OCV deviation change amounts of each battery cell.

According to some embodiments, the diagnosing of the state of the diagnosis target battery may include diagnosing that abnormality occurs in a first battery cell among the plurality of battery cells, when the plurality of OCV deviation change amounts of the first battery cell is greater than an upper limit of a normal range or is less than a lower limit of the normal range.

According to some embodiments, the obtaining of the first SOC data may include converting the first OCV data into the first SOC data based on an OCV-SOC mapping table, and the obtaining of the second OCV data may include converting the second SOC data into the second OCV data based on the OCV-SOC mapping table.

**[ADVANTAGEOUS EFFECTS]**

According to embodiments disclosed herein, there may be provided a battery diagnosis apparatus and method by which abnormality of a voltage behavior may be diagnosed even when there is a little change in a battery voltage.

The technical effects according to embodiments disclosed in the present document are not limited to the effects mentioned above, and other effects not mentioned will be clearly understood by those of ordinary skill in the art according to the disclosure of the present document.

## [DESCRIPTION OF DRAWINGS]

FIG. 1 illustrates components of a battery diagnosis system according to some embodiments.
FIG. 2 illustrates components of a battery diagnosis apparatus according to some embodiments.
FIG. 3 illustrates an operating process of a battery diagnosis apparatus according to some embodiments.
FIG. 4 illustrates a process of measuring an open circuit voltage (OCV) from a diagnosis target battery according to some embodiments.
FIG. 5 illustrates a process of generating actually measured OCV data according to some embodiments.
FIG. 6 illustrates a process of converting actually measured OCV data into estimated SOC data according to some embodiments.
FIG. 7 illustrates a process of calculating a relative capacity value of each battery cell based on an average SOC value according to some embodiments.
FIG. 8 illustrates a process of calculating a plurality of estimated OCV values based on a relative capacity value according to some embodiments.
FIG. 9 illustrates a process of generating estimated SOC data and estimated OCV data according to some embodiments.
FIG. 10 illustrates a process of converting estimated SOC data into estimated OCV data according to some embodiments.
FIG. 11 illustrates a process of deriving OCV deviation data based on a difference between actually measured OCV data and estimated OCV data according to some embodiments.
FIG. 12 illustrates a process of calculating a plurality of OCV deviation change amounts based on OCV deviation data according to some embodiments.
FIG. 13 illustrates a process of diagnosing a state of each battery cell based on a plurality of OCV deviation change amounts according to some embodiments.
FIG. 14 illustrates operations of a battery diagnosis method according to some embodiments.

## [MODE FOR INVENTION]

Hereinafter, embodiments disclosed herein will be described with reference to the accompanying drawings. However, the description is not intended to limit the disclosure of the present document to particular embodiments, and it should be construed as including various modifications, equivalents, and/or alternatives according to the embodiments described herein.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

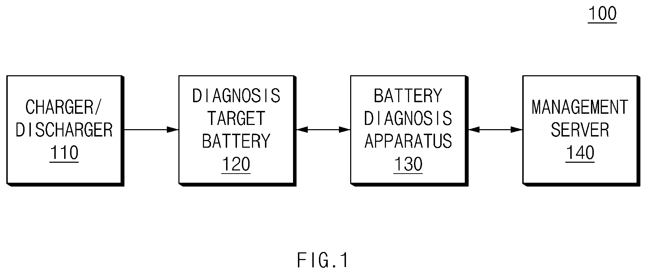

FIG. 1 illustrates components of a battery diagnosis system according to some embodiments.

Referring to FIG. 1, a battery diagnosis system 100 may include a charger/discharger 110, a diagnosis target battery 120, a battery diagnosis apparatus 130, and a management server 140. However, without being limited thereto, some components may be omitted from the battery diagnosis system 100 or other general-purpose components may be further included in the battery diagnosis system 100.

The battery diagnosis system 100 may refer to a system for diagnosing a state of the diagnosis target battery 120. According to an embodiment, a test voltage may be applied to the diagnosis target battery 120 by the charger/discharger 110, and response data output by the diagnosis target battery 120 in response to the test voltage may be measured by the battery diagnosis apparatus 130.

The charger/discharger 110 may be configured to charge or discharge the diagnosis target battery 120. According to an embodiment, the charger/discharger 110 may apply the test voltage to the diagnosis target battery 120, and the test voltage may include a plurality of charge/discharge cycle voltages. To this end, the charger/discharger 110 may include a power supply device for applying various types of voltage or current to the diagnosis target battery 120. According to an embodiment, the charger/discharger 110 may be included in the battery diagnosis apparatus 130 instead of being provided separately from the battery diagnosis apparatus 130.

The diagnosis target battery 120 may be a diagnosis target of the battery diagnosis system 100. The diagnosis target battery 120 may include a plurality of battery cells. For example, the diagnosis target battery 120 may include a plurality of battery modules, and each of the plurality of battery modules may include a plurality of battery cells. According to an embodiment, the diagnosis target battery 120 may include m battery cells, for each of which voltage measurement may be performed n times, such that m*n voltage measurement values may be generated.

The battery diagnosis apparatus 130 may perform operations for determining whether the diagnosis target battery 120 is abnormal. The battery diagnosis apparatus 130 may perform voltage measurement and data processing to diagnose which cell of the diagnosis target battery 120 has an abnormal voltage behavior.

The management server 140 may be configured to manage the state of the diagnosis target battery 120. The management server 140 may be connected to the battery diagnosis apparatus 130 through wired/wireless data communication, and may be provided with data such as the state, abnormality, and diagnosis result of the diagnosis target battery 120 from the battery diagnosis apparatus 130 and record the data. The management server 140 may control the battery diagnosis apparatus 130 or identify the state of the diagnosis target battery 120 at the request of a system manager or a battery user.

According to an embodiment, the management server 140 may perform at least some of operations for determining whether the diagnosis target battery 120 is abnormal on behalf of the battery diagnosis apparatus 130. The management server 140 may receive data necessary for diagnosing the diagnosis target battery 120 from the battery diagnosis apparatus 130, perform diagnosis procedures, and transmit a result to the battery diagnosis apparatus 130. According to an embodiment, the management server 140 may install energy management software necessary for diagnosing the diagnosis target battery 120 on the battery diagnosis apparatus 130 and provide update information of the energy management software to the battery diagnosis apparatus 130.

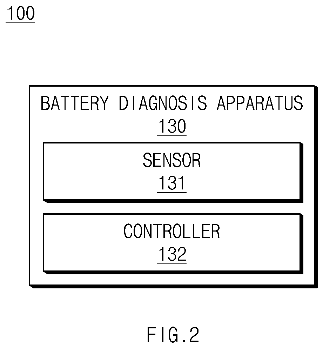

FIG. 2 illustrates components of a battery diagnosis apparatus according to some embodiments.

Referring to FIG. 2, the battery diagnosis apparatus 130 may include a sensor 131 and a controller 132. However, without being limited thereto, some components may be omitted from the battery diagnosis apparatus 130 or other general-purpose components may be further included in the battery diagnosis apparatus 130.

According to an embodiment, in the battery diagnosis apparatus 130, the sensor 131 and the controller 132 may be electrically connected to each other through communication between devices such as a bus, general purpose input and output (GPIO), serial peripheral interface (SPI), mobile industry processor interface (MIPI), etc.

The sensor 131 of the battery diagnosis apparatus 130 may be configured to measure the voltage from the diagnosis target battery 120. When a test cycle voltage is applied to the diagnosis target battery 120 by the charger/discharger 110, an output voltage may be generated in the diagnosis target battery 120 in response thereto, which may be measured by the sensor 131. To this end, the sensor 131 may include measuring means such as a voltmeter, an ammeter, a thermometer, etc.

The controller 132 may have a structure for executing instructions that implement the operations of the battery diagnosis apparatus 130. The controller 132 may be implemented with an array of multiple logic gates or a general-purpose microprocessor for processing various operations, and may include a single processor or a plurality of processors. For example, the controller 132 may be implemented in the form of at least one of a microprocessor, a CPU, a GPU, and an AP.

The controller 132 may be configured separately from or integrally with a memory (not shown) configured to store instructions, and may process various operations by executing the instructions stored in the memory. The memory may store various data, instructions, mobile applications, computer programs, etc. For example, the memory may be implemented in the form of non-volatile memory such as ROM, PROM, EPROM, EEPROM, flash memory, PRAM, MRAM, FRAM, etc., or volatile memory such as DRAM, SRAM, SDRAM, RRAM, HDD, SSD, SD, Micro- SD, etc., or may be implemented in the form of a combination thereof.

The sensor 131 of the battery diagnosis apparatus 130 may be configured to measure the OCV from the diagnosis target battery 120 and generate first OCV data OCVs. The first OCV data OCVs may mean actually measured OCV values. When a charge/discharge cycle voltage is applied to the diagnosis target battery 120, the sensor 131 may measure the voltage from the diagnosis target battery 120, and derive the OCV of the diagnosis target battery 120 based on the measured voltage. According to an embodiment, OCV values may be measured n times for each of the m battery cells of the diagnosis target battery 120, and the first OCV data may include m*n OCV values.

The controller 132 of the battery diagnosis apparatus 130 may be configured to obtain first state-of-charge data SOCs regarding the state of charge (SOC) of the diagnosis target battery 120 based on the first OCV data OCVs. For example, m*n OCV values of the first OCV data OCVs may be converted into m*n SOC values, and the first SOC data SOCs may include m*n SOC values. According to an embodiment, conversion of first OCV data OCVs into first SOC data SOCs may be performed based on an OCV-SOC mapping table.

The controller 132 of the battery diagnosis apparatus 130 may be configured to derive second SOC data SOCests for estimating the SOC of the diagnosis target battery 120 based on the first SOC data SOCs. The first SOC data SOCs may mean a value converted from the first OCV data OCVs, and the second SOC data SOCests may be a value obtained by estimating the SOC of the diagnosis target battery 120 through an estimation process. According to an embodiment, the second SOC data SOCests may be estimated based on an average SOC value and a relative capacity value of each battery cell.

The controller 132 of the battery diagnosis apparatus 130 may be configured to obtain second OCV data OCVests of the diagnosis target battery 120 based on the second SOC data SOCests. For example, the second SOC data SOCests may include m*n estimated SOC values that may be converted into m*n estimated OCV values. The second OCV data OCVests may include m*n estimated OCV values. According to an embodiment, conversion of the second SOC data SOCests into the second OCV data OCVests may be performed based on an OCV-SOC mapping table, which may be the same as a table for converting the first OCV data OCVs into the first SOC data SOCs.

The controller 132 of the battery diagnosis apparatus 130 may be configured to diagnose the state of the diagnosis target battery 120 based on the first OCV data OCVs and the second OCV data OCVests. According to an embodiment, the controller 132 of the battery diagnosis apparatus 130 may be configured to derive OCV deviation data OCVdevs based on a difference between the first OCV data OCVs and the second OCV data OCVests. For example, the first OCV data OCVs may include m*n actually measured OCV values, the second OCV data OCVests may contain m*n estimated OCV values, and a difference between the corresponding actually measured OCV value and estimated OCV value may produce m*n OCV deviation values. The OCV deviation data OCVdevs may include m*n OCV deviation values.

The controller 132 of the battery diagnosis apparatus 130 may be configured to diagnose the state of the diagnosis target battery 120 based on the OCV deviation data OCVdevs. According to the embodiment, the controller 132 may diagnose whether abnormality occurs in a voltage behavior of each battery cell of the diagnosis target battery 120 by comparing the OCV deviation data OCVdevs or a change amount thereof with a normal range. In this way, voltage behavior abnormality may be detected even when there is no sudden voltage change due to cell disconnection, short circuit, etc.

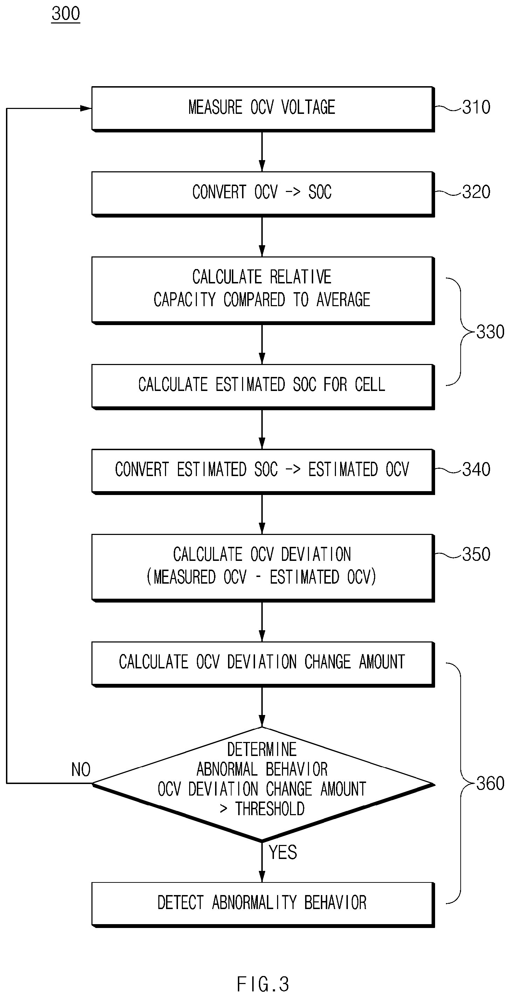

FIG. 3 illustrates an operating process of a battery diagnosis apparatus according to some embodiments.

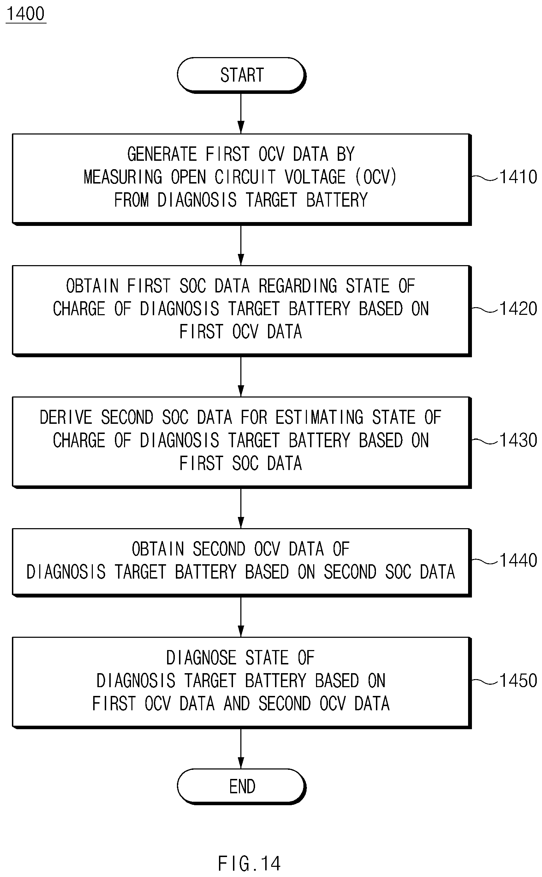

Referring to FIG. 3, an operating process 300 of the battery management apparatus 130 may include a first process 310 to a sixth process 360. The first process 310 to the sixth process 360 may correspond to operations 1410 to 1460 of FIG. 14 described later.

An OCV voltage of the diagnosis target battery 120 may be measured in the first process 310, the first OCV OCVs may be converted into the first SOC SOCs in the second process 320, and the estimated SOC data SOCests may be calculated based on the relative capacity value compared to the average SOC value in the third process 330.

The second SOC data SOCests may be converted into the second OCV data OCVests in the fourth process 340, a deviation between the first OCV data OCVs and the second OCV data OCVests may be calculated in the fifth process 350, an OCV deviation change amount may be calculated based on the OCV deviation data OCVdevs in the sixth process 360, such that by comparing the OCV deviation change amount with a threshold value, voltage behavior abnormality of each cell of the diagnosis target battery 120 may be diagnosed.

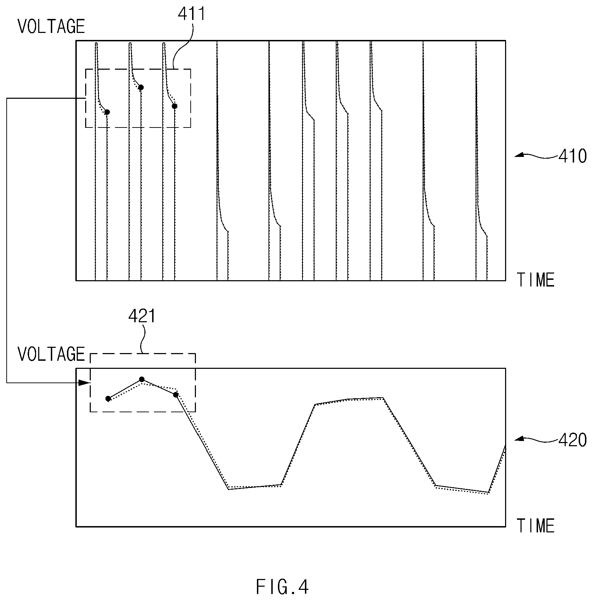

FIG. 4 illustrates a process of measuring an OCV from a diagnosis target battery according to some embodiments.

Referring to FIG. 4, a charge/discharge profile 410 and an OCV graph 420 of the diagnosis target battery 120 are shown.

The charge/discharge profile 410 may indicate a voltage measured from any one battery cell of the diagnosis target battery 120 when a charge/discharge cycle voltage is applied to the battery cell. According to an embodiment, peak values 411 in a measurement cycle of the charge/discharge profile 410 may be actually measured OCV values 421. For example, for one battery cell, the OCV graph 420 may include n actually measured OCV values 421.

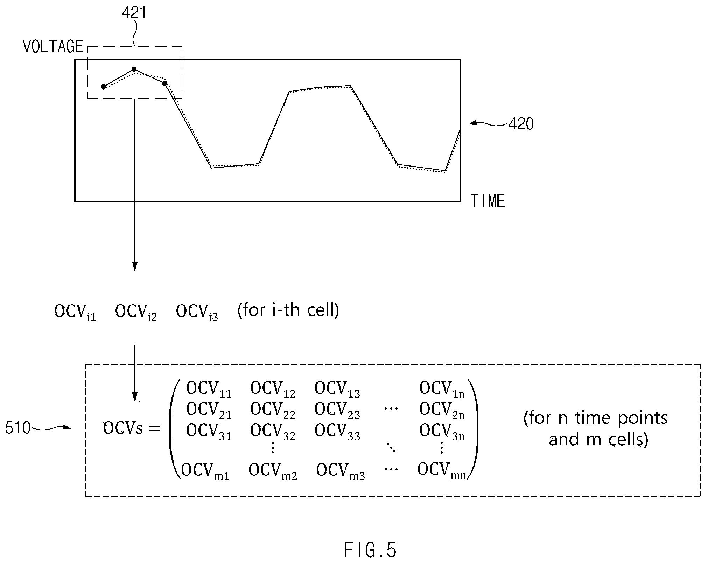

FIG. 5 illustrates a process of generating first OCV data according to some embodiments.

Referring to FIG. 5, the OCV graph 420 and first OCV data OCVs 510 of the diagnosis target battery 120 are shown.

The OCV graph 420 may include n actually measured OCV values 421 for an $i^{th}$ battery cell, and the first OCV data OCVs 510 for m battery cells of the diagnosis target battery 120 may be m*n actually measured OCV values. According to an embodiment, the first OCV data OCVs 510 may be expressed in the form of a matrix with a size of m*n.

According to an embodiment, the diagnosis target battery 120 may include a plurality of battery cells, and the first OCV data OCVs 510 may include a plurality of OCV values measured at a plurality of time points for each battery cell of the plurality of battery cells.

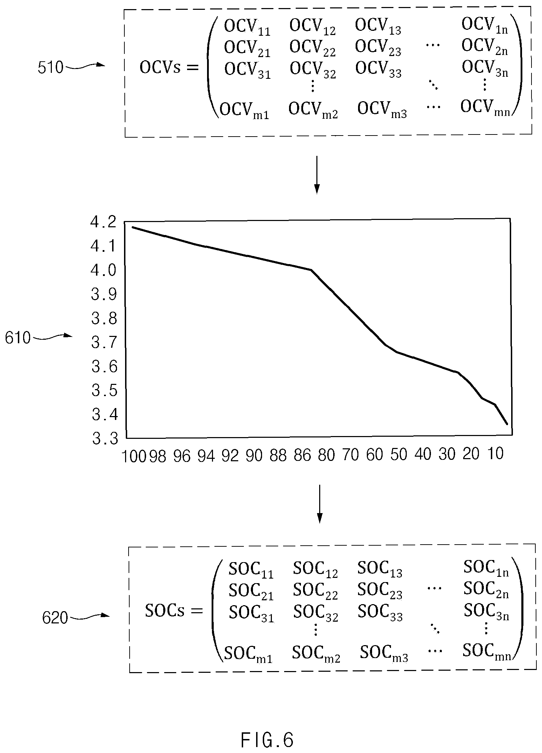

FIG. 6 illustrates a process of converting first OCV data into second SoC data according to some embodiments.

Referring to FIG. 6, the first OCV data OCVs 510, an OCV-SOC mapping table 610, and first SOC data SOCs 620 are shown.

According to an embodiment, the controller 132 of the battery diagnosis apparatus 130 may be configured to convert the first OCV data OCVs 510 into the first OSC data SOCs 620 based on the OCV-SOC mapping table 610. The OCV-SOC mapping table 610 may mean a table which maps an OCV value of a vertical axis to an SOC value of a horizontal axis and records a mapping relationship therebetween.

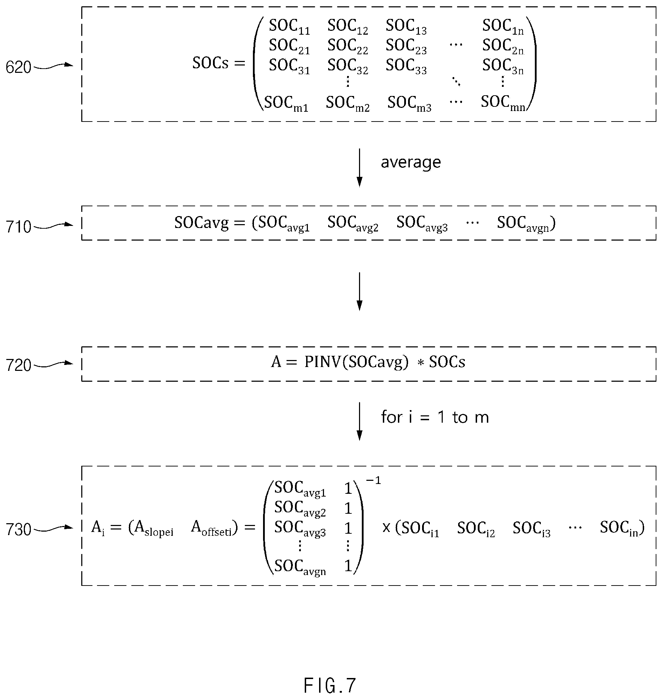

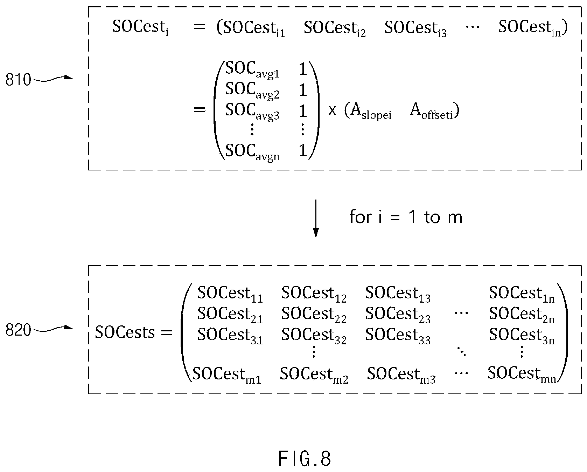

FIG. 7 illustrates a process of calculating a relative capacity value of each battery cell based on an average SOC value according to some embodiments, and FIG. 8 illustrates a process of calculating a plurality of estimated OCV values based on a relative capacity value according to some embodiments.

Referring to FIGS. 7 and 8, the first SOC data SOCs 620, an average SOC value SOCavg 710 for each of a plurality of time points 1, ..., n, relative capacity values A 720 and 730, a plurality of estimated SOC values $SOCest_i$ 810 for an ith battery cell, and second SOC data SOCests 820 of the diagnosis target battery 120 are shown.

For each of the plurality of time points 1, ..., n, an average of the first SOC data SOCs 620 may be calculated, and as a result, the average SOC value SOCavg 710 may be calculated. The relative capacity value A 720 may be calculated based on the average SOC value SOCavg 710 and the first SOC data SOCs 620.

In a manner of calculating a relative capacity value $A_i$ 730 from the first battery cell to the $m^{th}$ battery cell, the relative capacity value A 720 may be calculated. In this process, a pseudoinverse matrix (PINV) operation of the average SOCavg 710 may be performed. The pseudoinverse matrix may refer to a Moore-Penrose inverse matrix. The relative capacity value Ai 730 of the $i^{th}$ battery cell may include a slope component $A_{slopei}$ and an offset component $A_{offseti}$.

A plurality of estimated SOC values SOCesti 810 of the $i^{th}$ battery cell may be calculated based on the relative capacity value $A_i$ 730 and the average SOC value SOCavg 710 of the $i^{th}$ battery cell. The plurality of estimated SOC values $SOCest_i$ 810 of the ith battery cell may be calculated based on the slope component $A_{slopei}$, the offset component $A_{offseti}$, and the average SOC value SOCavg 710.

By calculating the plurality of estimated SOC values $SOCest_i$ 810 of the $i^{th}$ battery cell from the first battery cell to the $m^{th}$ battery cell, the second SOC data SOCests 820 of the diagnosis target battery 120 may be calculated.

According to an embodiment, the controller 132 of the battery diagnosis apparatus 130 may be configured to calculate the average SOC value SOCavg 710 of the plurality of SOC values converted from the plurality of OCV values for each battery cell, calculate the relative capacity value $A_i$ of each battery cell based on the average SOC value SOCavg 710, and calculate the plurality of estimated SOC values $SOCest_i$ of each battery cell at a plurality of time points based on the relative capacity value $A_i$.

According to an embodiment, the controller 132 of the battery diagnosis apparatus 130 may calculate the PINV

matrix ( $PINV(SOCavg) = \begin{pmatrix} SOC_{avg1} & 1 \\ SOC_{avg2} & 1 \\ SOC_{avg3} & 1 \\ \vdots & \vdots \\ SOC_{avgn} & 1 \end{pmatrix}^{-1}$ ) of the average SOC matrix $\begin{pmatrix} SOC_{avg1} & 1 \\ SOC_{avg2} & 1 \\ SOC_{avg3} & 1 \\ \vdots & \vdots \\ SOC_{avgn} & 1 \end{pmatrix}$ representing

the average SOC value SOCavg 710 of each battery cell, calculate the relative capacity matrix A representing the relative capacity value $A_i$) by multiplying the SOC matrix (SOC$_{i1}$ SOC$_{i2}$ SOC$_{i3}$ ··· SOC$_{in}$) representing the plurality of SOC values SOCs for each battery cell by the pseudoinverse matrix (PINV(SOCavg)).

According to an embodiment, the controller 132 of the battery diagnosis apparatus 130 may multiply the average

SOC matrix $\begin{pmatrix} SOC_{avg1} & 1 \\ SOC_{avg2} & 1 \\ SOC_{avg3} & 1 \\ \vdots & \vdots \\ SOC_{avgn} & 1 \end{pmatrix}$ representing the average SOC values of the battery cells by the relative capacity matrix A to calculate the estimated SOC matrix SOCests indicating the plurality of estimated SOC values SOCest$_i$ 810 of each battery cell.

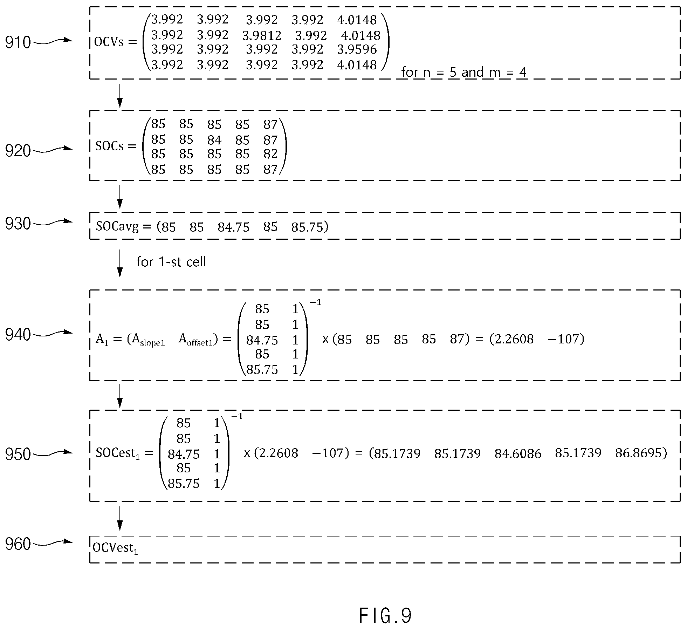

FIG. 9 illustrates a process of generating second SOC data and second OCV data according to some embodiments.

Referring to FIG. 9, a process of converting first OCV data OCVs 910 measured for four battery cells into second OSC data and second OCV data at five time points (n = 5) is shown.

The first OCV data OCVs 910 may be converted into the first SOC data SOCs 920 based on the OCV-SOC mapping table 610. An average SOC value SOCavg 930 may be calculated based on the first SOC data SOCs 920.

A relative capacity value $A_1$ 940 for the first battery cell may be calculated by multiplying a pseudoinverse matrix

$\begin{pmatrix} 85 & 1 \\ 85 & 1 \\ 84.75 & 1 \\ 85 & 1 \\ 85.75 & 1 \end{pmatrix}^{-1}$ of an average SOC matrix $\begin{pmatrix} 85 & 1 \\ 85 & 1 \\ 84.75 & 1 \\ 85 & 1 \\ 85.75 & 1 \end{pmatrix}$ by the average SOC value SOCavg 930, for the first battery cell (i = 1) among four battery cells based on the average SOC value SOCavg 930. Thereafter, by multiplying

the pseudoinverse matrix $\begin{pmatrix} 85 & 1 \\ 85 & 1 \\ 84.75 & 1 \\ 85 & 1 \\ 85.75 & 1 \end{pmatrix}^{-1}$ of the average SOC matrix $\begin{pmatrix} 85 & 1 \\ 85 & 1 \\ 84.75 & 1 \\ 85 & 1 \\ 85.75 & 1 \end{pmatrix}$ by the relative capacity

value $A_1$ 940, estimated SOC values SOCest$_1$ 950 for the first battery cell may be calculated, and the OCV-SOC mapping table 610 may be applied thereto to calculate estimated OCV values OCVest$_1$ 960 for the first battery cell.

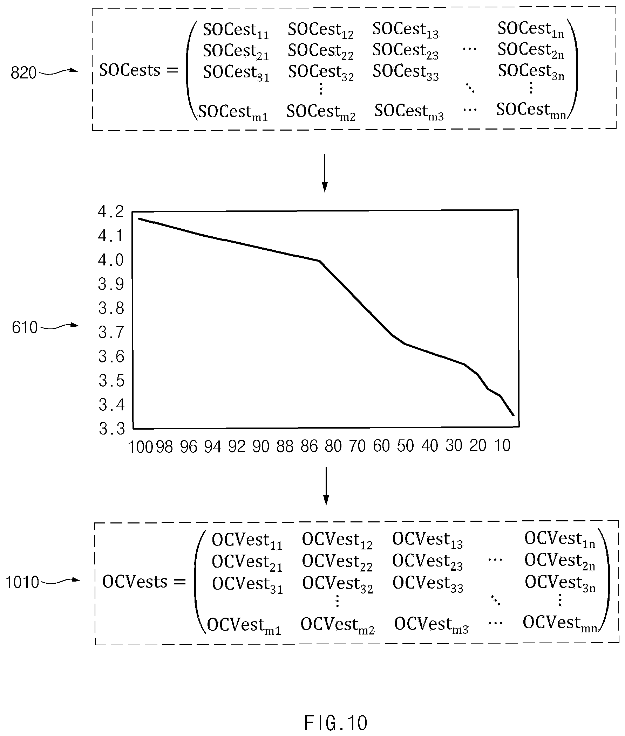

FIG. 10 illustrates a process of converting second SOC data into second OCV data according to some embodiments.

Referring to FIG. 10, a process of converting second SOC data SOCests 820 of the diagnosis target battery 120 into second OCV data OCVests 1010 based on the OCV-SOC mapping table 610 is shown.

According to an embodiment, the controller 132 of the battery diagnosis apparatus 130 may be configured to convert the second OCV data SOCests 820 into the second OCV data OCVests 1010 based on the OCV-SOC mapping table 610. Herein, the OCV-SOC mapping table 610 may be the same as a table used for converting the first OCV data OCVs 510 into the first SOC data SOCs 620.

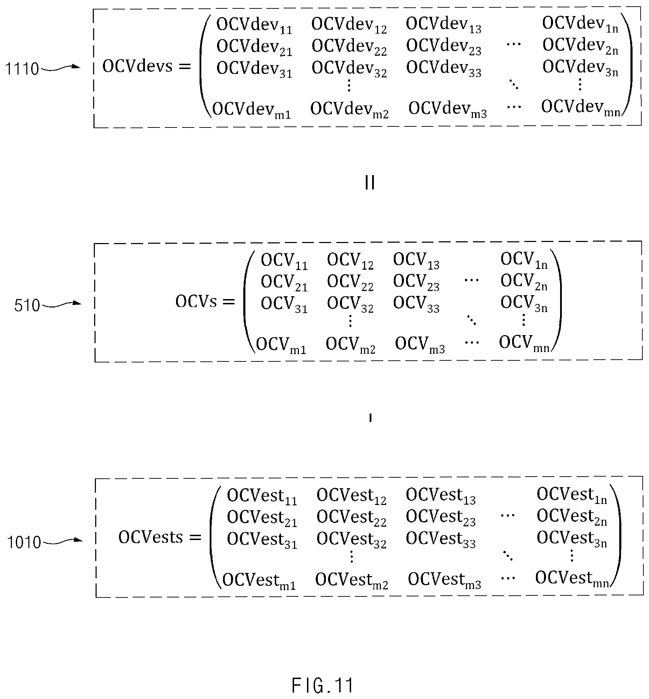

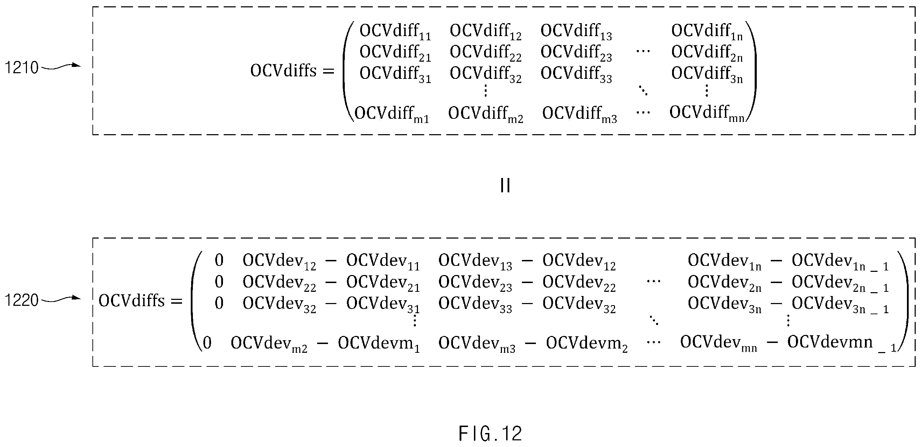

FIG. 11 illustrates a process of deriving OCV deviation data based on a difference between first OCV data and second OCV data according to some embodiments, and FIG. 12 illustrates a process of calculating a plurality of OCV deviation change amounts based on OCV deviation data according to some embodiments.

Referring to FIG. 11, a process of deriving OCV deviation data OCVdevs 1110 based on a difference between the first OCV data OCVs 510 and the second OCV data OCVests 1010 is shown, and referring to FIG. 12, a process of calculating a plurality of OCV deviation change amounts 1210 and 1220 based on a difference between a value at a current time point and a value at a previous time point of the OCV deviation data OCVdevs 1110 is shown.

According to an embodiment an embodiment, the OCV deviation data OCVdevs 1110 may include a plurality of OCV deviation values OCVdev$_{i1}$, OCVdev$_{i2}$, ..., OCVdev$_{in}$ of each battery cell at a plurality of time points 1 to n. According to an embodiment, the controller 132 of the battery diagnosis apparatus 130 may be configured to calculate a plurality of OCV deviation change amounts OCVdiff$_i$ 1210 indicating a difference 1220 between an OCV deviation value at a current time point and an OCV deviation value at a previous time point based on the plurality of OCV deviation values OCVdev$_{i1}$,

OCVdev$_{i2}$, ..., OCVdev$_{in}$ of each battery cell, and diagnose a state of each battery cell based on the plurality of OCV deviation change amounts OCVdiff$_i$ 1210 of each battery cell.

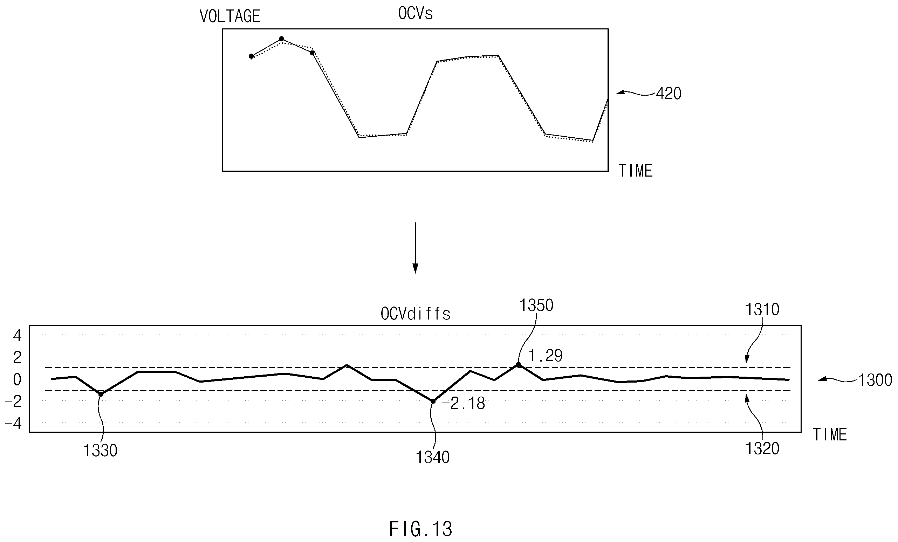

FIG. 13 illustrates a process of diagnosing a state of each battery cell based on a plurality of OCV deviation change amounts according to some embodiments.

Referring to FIG. 13, in a diagnosis process of the diagnosis target battery 120, upon input of the first OCV data OCVs 420, OCV deviation change amounts OCVdiffs 1300 including the plurality of OCV deviation change amounts OCVdiff$_i$ 1210 of each battery cell may be derived, and voltage behavior abnormality of each battery cell of the diagnosis target battery 120 may be detected based on the OCV deviation change amount OCVdiffs 1300.

In the OCV deviation change amount OCVdiffs 1300, an upper limit 1310 and a lower limit 1320 in a normal range may be set. According to an embodiment, when an OCV deviation change amount of a specific battery cell exceeds the upper limit 1310 or falls short of the lower limit 1320 at a specific time point, it may be diagnosed that voltage behavior abnormality occurs in the corresponding battery cell at excess/shortfall time points. For example, when the OCV deviation change amount falls out of a normal range at shortfall time points 1330 and 1340 and an excess time point 1350, a battery cell having the OCV deviation change amount OCVdiffs 1300 may be diagnosed as an abnormal cell.

According to an embodiment, the upper limit 1310 and the lower limit 1320 of the normal range may be changed depending on battery performance requirements. When high battery performance requirements are needed, the normal range may be narrowed, and in the opposite case, the normal range may be widened. According to an embodiment, abnormality of the battery cell may be diagnosed based on the number and/or frequency that the battery performance requirements fall out of the normal range. For example, the number and/or frequency that the battery performance requirements fall out of the normal range may be compared with a threshold value.

FIG. 14 illustrates operations of a battery diagnosis method according to some embodiments.

Referring to FIG. 14, the battery diagnosis method 1400 may include operations 1410 to 1460. However, without being limited thereto, some operations may be omitted and other general-purpose operations may be added, and operations of the battery diagnosis method 1400 may be executed in an order different from that shown.

The battery diagnosis method 1400 may include operations processed in time series by the battery diagnosis apparatus 130. Therefore, matters described for the battery diagnosis apparatus 130 above, even omitted below, may be equally applied to the battery diagnosis method 1400.

Operations 1410 to 1460 of the battery diagnosis method 1400 may be performed by the sensor 131 and the controller 132 of the battery diagnosis apparatus 130.

In operation 1410, the battery diagnosis apparatus 130 may generate first OCV data by measuring an OCV from a diagnosis target battery.

In operation 1420, the battery diagnosis apparatus 130 may obtain first SOC data regarding an SOC of a diagnosis target battery based on the first OCV data.

In operation 1430, the battery diagnosis apparatus 130 may derive second SOC data for estimating the SOC of the diagnosis target battery based on the first SOC data.

In operation 1440, the battery diagnosis apparatus 130 may obtain second OCV data of the diagnosis target battery based on the second SOC data.

In operation 1450, the battery diagnosis apparatus 130 may diagnose the state of the diagnosis target battery based on the first OCV data and the second OCV data.

Meanwhile, the battery diagnosis method 1400 may be implemented in the form of a computer program stored in a computer-readable storage medium. That is, the computer program may include instructions for implementing the battery diagnosis method 1400, and the instructions of the program may be stored in a computer-readable storage medium. The computer programs may include mobile applications.

For example, the computer-readable storage medium may include magnetic media such as hard disk, floppy disk, and magnetic tape, optical media such as compact disk read only memory (CD-ROM) and digital versatile disk (DVD), magneto-optical media such as floptical disk, and a hardware device especially configured to store and execute program instructions, such as read only memory (ROM), random access memory (RAM) and flash memory, etc. The computer program instructions may include a machine language code created by a complier and a high-level language code executable by a computer using an interpreter.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The above description is merely illustrative of the technical idea of the present disclosure, and various modifications and variations will be possible without departing from the essential characteristics of embodiments of the present disclosure by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

[Description of Symbols]

| 100: | Battery Diagnosis System | 110: | Charger/Discharger |
|------|--------------------------|------|--------------------|
| 120: | Diagnosis Target Battery | 130: | Battery Diagnosis Apparatus |
| 131: | Sensor | 132: | Controller |
| 140: | Management Server | | |

**Claims**

1. A battery diagnosis apparatus comprising:

   a sensor configured to generate first open circuit voltage (OCV) data by measuring an OCV from a diagnosis target battery; and
   a controller configured to:
   obtain first SOC data regarding a state of charge (SOC) of the diagnosis target battery based on the first OCV data;
   derive second SOC data for estimating the SOC of the diagnosis target battery based on the first SOC data;
   obtain second OCV data of the diagnosis target battery based on the second SOC data; and
   diagnose a state of the diagnose target battery based on the first OCV data and the second OCV data.

2. The battery diagnosis apparatus of claim 1, wherein the diagnosis target battery comprises a plurality of battery cells, and
   the first OCV data comprises a plurality of OCV values measured at a plurality of time points for each of the plurality of battery cells.

3. The battery diagnosis apparatus of claim 2, wherein the controller is further configured to:

   calculate an average SOC value of a plurality of SOC values converted from the plurality of OCV values for each battery cell;
   calculate a relative capacity value of each battery cell based on the average SOC value; and
   calculate a plurality of estimated SOC values of each battery cell at the plurality of time points based on the relative capacity value.

4. The battery diagnosis apparatus of claim 3, wherein the controller is further configured to:

   calculate a pseudoinverse matrix of an average SOC matrix indicating the average SOC value of each battery cell; and
   calculate a relative capacity matrix indicating the relative capacity value by multiplying the pseudoinverse matrix by an SOC matrix indicating the plurality of SOC values for each battery cell.

5. The battery diagnosis apparatus of claim 4, wherein the controller is further configured to calculate an estimated SOC matrix indicating the plurality of estimated SOC values of each battery cell by multiplying the average SOC matrix by the relative capacity matrix.

6. The battery diagnosis apparatus of claim 1, wherein the controller is further configured to:

   derive OCV deviation data based on a difference between the first OCV data and the second OCV data; and

**EP 4 560 330 A2**

diagnose the state of the diagnose target battery based on the OCV deviation data.

7. The battery diagnosis apparatus of claim 6, wherein the OCV deviation data comprises a plurality of OCV deviation values of each battery cell at the plurality of time points, and
the controller is further configured to:

calculate a plurality of OCV deviation change amounts indicating a difference between an OCV deviation value at a current time point and an OCV deviation value at a previous time point, based on the plurality of OCV deviation values of each battery cell; and
diagnose a state of each battery cell based on the plurality of OCV deviation change amounts of each battery cell.

8. The battery diagnosis apparatus of claim 7, wherein the controller is further configured to diagnose that abnormality occurs in a first battery cell among the plurality of battery cells, when the plurality of OCV deviation change amounts of the first battery cell is greater than an upper limit of a normal range or is less than a lower limit of the normal range.

9. The battery diagnosis apparatus of claim 1, wherein
the controller is further configured to:

convert the first OCV data into the first SOC data based on an OCV-SOC mapping table; and
convert the second SOC data into the second OCV data based on the OCV-SOC mapping table.

10. A battery diagnosis method comprising:

generating first open circuit voltage (OCV) data by measuring an OCV from a diagnosis target battery;
obtaining first SOC data regarding a state of charge (SOC) of the diagnosis target battery based on the first OCV data;
deriving second SOC data for estimating the SOC of the diagnosis target battery based on the first SOC data;
obtaining second OCV data of the diagnosis target battery based on the second SOC data; and
diagnosing a state of the diagnose target battery based on the first OCV data and the second OCV data.

11. The battery diagnosis method of claim 10, wherein the diagnosis target battery comprises a plurality of battery cells, and
the first OCV data comprises a plurality of OCV values measured at a plurality of time points for each of the plurality of battery cells.

12. The battery diagnosis method of claim 11, wherein the deriving of the second SOC data comprises:

calculating an average SOC value of a plurality of SOC values converted from the plurality of OCV values for each battery cell;
calculating a relative capacity value of each battery cell based on the average SOC value; and
calculating a plurality of estimated SOC values of each battery cell at the plurality of time points based on the relative capacity value.

13. The battery diagnosis method of claim 12, wherein the calculating of the relative capacity value comprises:

calculating a pseudoinverse matrix of an average SOC matrix indicating the average SOC value of each battery cell; and
calculating a relative capacity matrix indicating the relative capacity value by multiplying the pseudoinverse matrix by an SOC matrix indicating the plurality of SOC values for each battery cell.

14. The battery diagnosis method of claim 13, wherein the calculating of the plurality of estimated SOC values comprises calculating an estimated SOC matrix indicating the plurality of estimated SOC values of each battery cell by multiplying the average SOC matrix by the relative capacity matrix.

15. The battery diagnosis method of claim 10, wherein the diagnosing of the state of the diagnosis target battery comprises:

deriving OCV deviation data based on a difference between the first OCV data and the second OCV data; and

diagnosing a state of the diagnose target battery based on the OCV deviation data.

16. The battery diagnosis method of claim 15, wherein the OCV deviation data comprises a plurality of OCV deviation values of each battery cell at the plurality of time points, and
the diagnosing of the state of the diagnosis target battery comprises:

calculating a plurality of OCV deviation change amounts indicating a difference between an OCV deviation value at a current time point and an OCV deviation value at a previous time point, based on the plurality of OCV deviation values of each battery cell; and
diagnosing a state of each battery cell based on the plurality of OCV deviation change amounts of each battery cell.

17. The battery diagnosis method of claim 16, wherein the diagnosing of the state of the diagnosis target battery comprises diagnosing that abnormality occurs in a first battery cell among the plurality of battery cells, when the plurality of OCV deviation change amounts of the first battery cell is greater than an upper limit of a normal range or is less than a lower limit of the normal range.

18. The battery diagnosis method of claim 10, wherein the obtaining of the first SOC data comprises converting the first OCV data into the first SOC data based on an OCV-SOC mapping table, and
the obtaining of the second OCV data comprises converting the second SOC data into the second OCV data based on the OCV-SOC mapping table.

100

```
┌─────────────┐     ┌─────────────┐     ┌─────────────┐     ┌─────────────┐
│  CHARGER/   │     │ DIAGNOSIS   │     │  BATTERY    │     │ MANAGEMENT  │
│ DISCHARGER  │ ──> │  TARGET     │ <─> │ DIAGNOSIS   │ <─> │  SERVER     │
│    110      │     │ BATTERY     │     │ APPARATUS   │     │    140      │
│             │     │    120      │     │    130      │     │             │
└─────────────┘     └─────────────┘     └─────────────┘     └─────────────┘
```

FIG.1

100

```
┌─────────────────────────────────────────┐
│  BATTERY DIAGNOSIS APPARATUS            │
│              130                        │
│  ┌───────────────────────────────────┐ │
│  │            SENSOR                 │ │
│  │             131                   │ │
│  └───────────────────────────────────┘ │
│  ┌───────────────────────────────────┐ │
│  │          CONTROLLER               │ │
│  │             132                   │ │
│  └───────────────────────────────────┘ │
└─────────────────────────────────────────┘
```

FIG.2

300

```
┌─────────────────────────────────────┐
│        MEASURE OCV VOLTAGE           │─── 310
└─────────────────────────────────────┘
                    │
                    ▼
┌─────────────────────────────────────┐
│         CONVERT OCV -> SOC           │─── 320
└─────────────────────────────────────┘
                    │
                    ▼
┌─────────────────────────────────────┐
│        CALCULATE RELATIVE            │
│     CAPACITY COMPARED TO AVERAGE     │
└─────────────────────────────────────┘    } 330
                    │
                    ▼
┌─────────────────────────────────────┐
│     CALCULATE ESTIMATED SOC FOR CELL │
└─────────────────────────────────────┘
                    │
                    ▼
┌─────────────────────────────────────┐
│   CONVERT ESTIMATED SOC -> ESTIMATED OCV │─── 340
└─────────────────────────────────────┘
                    │
                    ▼
┌─────────────────────────────────────┐
│       CALCULATE OCV DEVIATION        │─── 350
│   (MEASURED OCV - ESTIMATED OCV)     │
└─────────────────────────────────────┘
                    │
                    ▼
┌─────────────────────────────────────┐
│   CALCULATE OCV DEVIATION CHANGE AMOUNT │
└─────────────────────────────────────┘
                    │
                    ▼
                  DETERMINE
        NO    ABNORMAL BEHAVIOR
        ◄──  OCV DEVIATION CHANGE AMOUNT      } 360
               > THRESHOLD
                    │ YES
                    ▼
┌─────────────────────────────────────┐
│      DETECT ABNORMALITY BEHAVIOR     │
└─────────────────────────────────────┘
```

FIG.3

FIG.4

EP 4 560 330 A2

421

VOLTAGE

420

TIME

$OCV_{i1}$  $OCV_{i2}$  $OCV_{i3}$  (for i-th cell)

510

$$OCVs = \begin{pmatrix} OCV_{11} & OCV_{12} & OCV_{13} & & OCV_{1n} \\ OCV_{21} & OCV_{22} & OCV_{23} & \cdots & OCV_{2n} \\ OCV_{31} & OCV_{32} & OCV_{33} & & OCV_{3n} \\ & \vdots & & \ddots & \vdots \\ OCV_{m1} & OCV_{m2} & OCV_{m3} & \cdots & OCV_{mn} \end{pmatrix}$$

(for n time points and m cells)

FIG.5

$$510 \rightarrow \quad OCVs = \begin{pmatrix} OCV_{11} & OCV_{12} & OCV_{13} & & OCV_{1n} \\ OCV_{21} & OCV_{22} & OCV_{23} & \cdots & OCV_{2n} \\ OCV_{31} & OCV_{32} & OCV_{33} & & OCV_{3n} \\ & \vdots & & \ddots & \vdots \\ OCV_{m1} & OCV_{m2} & OCV_{m3} & \cdots & OCV_{mn} \end{pmatrix}$$

$$620 \rightarrow \quad SOCs = \begin{pmatrix} SOC_{11} & SOC_{12} & SOC_{13} & & SOC_{1n} \\ SOC_{21} & SOC_{22} & SOC_{23} & \cdots & SOC_{2n} \\ SOC_{31} & SOC_{32} & SOC_{33} & & SOC_{3n} \\ & \vdots & & \ddots & \vdots \\ SOC_{m1} & SOC_{m2} & SOC_{m3} & \cdots & SOC_{mn} \end{pmatrix}$$

FIG.6

620

$$SOCs = \begin{pmatrix} SOC_{11} & SOC_{12} & SOC_{13} & & SOC_{1n} \\ SOC_{21} & SOC_{22} & SOC_{23} & \cdots & SOC_{2n} \\ SOC_{31} & SOC_{32} & SOC_{33} & & SOC_{3n} \\ & \vdots & & \ddots & \vdots \\ SOC_{m1} & SOC_{m2} & SOC_{m3} & \cdots & SOC_{mn} \end{pmatrix}$$

↓ average

710

$$SOCavg = (SOC_{avg1} \quad SOC_{avg2} \quad SOC_{avg3} \quad \cdots \quad SOC_{avgn})$$

↓

720

$$A = PINV(SOCavg) * SOCs$$

↓ for i = 1 to m

730

$$A_i = (A_{slopei} \quad A_{offseti}) = \begin{pmatrix} SOC_{avg1} & 1 \\ SOC_{avg2} & 1 \\ SOC_{avg3} & 1 \\ \vdots & \vdots \\ SOC_{avgn} & 1 \end{pmatrix}^{-1} \times (SOC_{i1} \quad SOC_{i2} \quad SOC_{i3} \quad \cdots \quad SOC_{in})$$

FIG.7

$$SOCest_i = (SOCest_{i1} \quad SOCest_{i2} \quad SOCest_{i3} \quad \cdots \quad SOCest_{in})$$

$$810 \qquad = \begin{pmatrix} SOC_{avg1} & 1 \\ SOC_{avg2} & 1 \\ SOC_{avg3} & 1 \\ \vdots & \vdots \\ SOC_{avgn} & 1 \end{pmatrix} \times (A_{slopei} \quad A_{offseti})$$

for i = 1 to m

$$820 \qquad SOCests = \begin{pmatrix} SOCest_{11} & SOCest_{12} & SOCest_{13} & & SOCest_{1n} \\ SOCest_{21} & SOCest_{22} & SOCest_{23} & \cdots & SOCest_{2n} \\ SOCest_{31} & SOCest_{32} & SOCest_{33} & & SOCest_{3n} \\ & \vdots & & \ddots & \vdots \\ SOCest_{m1} & SOCest_{m2} & SOCest_{m3} & \cdots & SOCest_{mn} \end{pmatrix}$$

FIG.8

910 →
$$OCVs = \begin{pmatrix} 3.992 & 3.992 & 3.992 & 3.992 & 4.0148 \\ 3.992 & 3.992 & 3.9812 & 3.992 & 4.0148 \\ 3.992 & 3.992 & 3.992 & 3.992 & 3.9596 \\ 3.992 & 3.992 & 3.992 & 3.992 & 4.0148 \end{pmatrix}$$ for n = 5 and m = 4

920 →
$$SOCs = \begin{pmatrix} 85 & 85 & 85 & 85 & 87 \\ 85 & 85 & 84 & 85 & 87 \\ 85 & 85 & 85 & 85 & 82 \\ 85 & 85 & 85 & 85 & 87 \end{pmatrix}$$

930 → $SOCavg = (85 \quad 85 \quad 84.75 \quad 85 \quad 85.75)$

for 1-st cell

940 →
$$A_1 = (A_{slope1} \quad A_{offset1}) = \begin{pmatrix} 85 & 1 \\ 85 & 1 \\ 84.75 & 1 \\ 85 & 1 \\ 85.75 & 1 \end{pmatrix}^{-1} \times (85 \quad 85 \quad 85 \quad 85 \quad 87) = (2.2608 \quad -107)$$

950 →
$$SOCest_1 = \begin{pmatrix} 85 & 1 \\ 85 & 1 \\ 84.75 & 1 \\ 85 & 1 \\ 85.75 & 1 \end{pmatrix}^{-1} \times (2.2608 \quad -107) = (85.1739 \quad 85.1739 \quad 84.6086 \quad 85.1739 \quad 86.8695)$$

960 → $OCVest_1$

FIG.9

$$820 \longrightarrow \quad SOCests = \begin{pmatrix} SOCest_{11} & SOCest_{12} & SOCest_{13} & & SOCest_{1n} \\ SOCest_{21} & SOCest_{22} & SOCest_{23} & \cdots & SOCest_{2n} \\ SOCest_{31} & SOCest_{32} & SOCest_{33} & & SOCest_{3n} \\ & \vdots & & \ddots & \vdots \\ SOCest_{m1} & SOCest_{m2} & SOCest_{m3} & \cdots & SOCest_{mn} \end{pmatrix}$$

$$1010 \longrightarrow \quad OCVests = \begin{pmatrix} OCVest_{11} & OCVest_{12} & OCVest_{13} & & OCVest_{1n} \\ OCVest_{21} & OCVest_{22} & OCVest_{23} & \cdots & OCVest_{2n} \\ OCVest_{31} & OCVest_{32} & OCVest_{33} & & OCVest_{3n} \\ & \vdots & & \ddots & \vdots \\ OCVest_{m1} & OCVest_{m2} & OCVest_{m3} & \cdots & OCVest_{mn} \end{pmatrix}$$

FIG.10

1110

$$OCVdevs = \begin{pmatrix} OCVdev_{11} & OCVdev_{12} & OCVdev_{13} & & OCVdev_{1n} \\ OCVdev_{21} & OCVdev_{22} & OCVdev_{23} & \cdots & OCVdev_{2n} \\ OCVdev_{31} & OCVdev_{32} & OCVdev_{33} & & OCVdev_{3n} \\ & \vdots & & \ddots & \vdots \\ OCVdev_{m1} & OCVdev_{m2} & OCVdev_{m3} & \cdots & OCVdev_{mn} \end{pmatrix}$$

$$\parallel$$

510

$$OCVs = \begin{pmatrix} OCV_{11} & OCV_{12} & OCV_{13} & & OCV_{1n} \\ OCV_{21} & OCV_{22} & OCV_{23} & \cdots & OCV_{2n} \\ OCV_{31} & OCV_{32} & OCV_{33} & & OCV_{3n} \\ & \vdots & & \ddots & \vdots \\ OCV_{m1} & OCV_{m2} & OCV_{m3} & \cdots & OCV_{mn} \end{pmatrix}$$

$$\vert$$

1010

$$OCVests = \begin{pmatrix} OCVest_{11} & OCVest_{12} & OCVest_{13} & & OCVest_{1n} \\ OCVest_{21} & OCVest_{22} & OCVest_{23} & \cdots & OCVest_{2n} \\ OCVest_{31} & OCVest_{32} & OCVest_{33} & & OCVest_{3n} \\ & \vdots & & \ddots & \vdots \\ OCVest_{m1} & OCVest_{m2} & OCVest_{m3} & \cdots & OCVest_{mn} \end{pmatrix}$$

FIG.11

1210

$$OCVdiffs = \begin{pmatrix} OCVdiff_{11} & OCVdiff_{12} & OCVdiff_{13} & & OCVdiff_{1n} \\ OCVdiff_{21} & OCVdiff_{22} & OCVdiff_{23} & \cdots & OCVdiff_{2n} \\ OCVdiff_{31} & OCVdiff_{32} & OCVdiff_{33} & & OCVdiff_{3n} \\ & \vdots & & \ddots & \vdots \\ OCVdiff_{m1} & OCVdiff_{m2} & OCVdiff_{m3} & \cdots & OCVdiff_{mn} \end{pmatrix}$$

$$=$$

1220

$$OCVdiffs = \begin{pmatrix} 0 & OCVdev_{12} - OCVdev_{11} & OCVdev_{13} - OCVdev_{12} & & OCVdev_{1n} - OCVdev_{1n\_1} \\ 0 & OCVdev_{22} - OCVdev_{21} & OCVdev_{23} - OCVdev_{22} & \cdots & OCVdev_{2n} - OCVdev_{2n\_1} \\ 0 & OCVdev_{32} - OCVdev_{31} & OCVdev_{33} - OCVdev_{32} & & OCVdev_{3n} - OCVdev_{3n\_1} \\ & \vdots & & \ddots & \vdots \\ 0 & OCVdev_{m2} - OCVdevm_1 & OCVdev_{m3} - OCVdevm_2 & \cdots & OCVdev_{mn} - OCVdevmn\_1 \end{pmatrix}$$

FIG.12

VOLTAGE          OCVs

420

OCVdiffs          1350          1310

1.29

−2.18          1300

1330          1340          1320

TIME

FIG.13

1400

FIG.14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220120916

- KR 1020230102473